# EUROPEAN PATENT APPLICATION

(11) **EP 3 699 237 A1**
(43) Date of publication of application: **26.08.2020**
(21) Application number: 18868937.6
(22) Date of filing: 05.10.2018
(51) Int. Cl.: C08L 83/07, C08L 83/05, H01L 23/29, H01L 23/31

(54) **CURABLE SILICONE COMPOSITION AND OPTICAL SEMICONDUCTOR DEVICE**

(30) Priority: 20.10.2017 JP 2017203349
(71) Applicant: DuPont Toray Specialty Materials Kabushiki Kaisha, Tokyo 100-6111 (JP); Dow Silicones Corporation, Midland, MI 48686-0994 (US)
(72) Inventor: IIMURA, Tomohiro, Ichihara-shi Chiba 299-0108 (JP); NISHIJIMA, Kazuhiro, Ichihara-shi Chiba 299-0108 (JP); PARK, Yungjin, Cheongju-si Chungcheongbuk-do (KR)
(74) Representative: Murgitroyd & Company
(86) International application number: PCT/JP2018/037485
(87) International publication number: WO 2019/078046

(57) **Abstract**

[Problem] To provide a curable silicone composition whereby an optical semiconductor device can be formed that has good efficiency of light extraction from a light-emitting element and a small rate of change, and an optical semiconductor device having good efficiency of light extraction from a light-emitting element and a small rate of change over time. [Solution] A curable silicone composition including at least: (A) an organopolysiloxane represented by an average composition formula and having at least two alkenyl groups in the molecule thereof; (B) an organopolysiloxane having at least two silicon-atom-bonded hydrogen atoms in the molecule thereof, at least 5 mol% of silicon-atom-bonded groups other than hydrogen atoms being aryl groups; (C) an organopolysiloxane represented by an average unit formula and having an alkenyl group, an aryl group, and an epoxy-containing organic group; and (D) a hydrosilylation catalyst.

## Description

### [Technical field]

The present invention relates to a curable silicone composition, and to an optical semiconductor device manufactured using said composition.

### [Background technology]

Curable silicone compositions, when cured, form cured products having excellent transparency, electrical insulation, heat resistance, and weather resistance, and are therefore used as electrical/electronic component sealants, adhesives and coatings. Examples of such curable silicone compositions are curable silicone compositions comprising: organopolysiloxane having alkenyl groups and phenyl groups; organopolysiloxane having silicon atom-bonded hydrogen atom(s) per molecule;
organopolysiloxane having epoxy-containing organic groups and alkenyl groups;
and hydrosilylation catalyst (see Patent Document 1); and
curable silicone compositions comprising: organopolysiloxane having at least 2 alkenyl groups per molecule, wherein at least 30 mol% of all the silicon atom-bonded organic groups are aryl groups;
organopolysiloxane having at least 2 silicon atom-bonded hydrogen atoms per molecule, wherein at least 15 mol% of all the silicon atom-bonded organic groups are aryl groups;
organopolysiloxane wherein, of all the silicon atom-bonded organic groups per molecule, at least 5 mol% are alkenyl groups, at least 15 mol% are aryl groups, and at least 10 mol% are epoxy-containing organic groups;
and hydrosilylation catalyst (see Patent Document 2).

When such a curable silicone composition is used as light-emitting element sealant in an optical semiconductor device such as a light-emitting diode (LED), the wavelength of the light emitted from the light-emitting element changes, and so a phosphor is incorporated into the curable silicone composition. However, it is known that optical semiconductor devices manufactured using these curable silicone compositions are disadvantageous in that the light extraction efficiency is insufficient and the light extraction efficiency changes over time.

### [Prior art documents]

### [Patent documents]

[Patent document 1] Japanese Unexamined Patent Publication No. 2007-008996
[Patent document 2] Japanese Unexamined Patent Publication No. 2010-001335

### [Disclosure of the invention]

### [Problem to be solved by the invention]

The aim of the present invention is the provision of a curable silicone composition that can form an optical semiconductor device having a light extraction efficiency from the light-emitting element that is good and has a low rate of change over time, and the provision of an optical semiconductor device having a light extraction efficiency from the light-emitting element that is good and has a low rate of change over time.

### [Means of solving the problem]

The inventive curable silicone composition is characterized in that it comprises at least
(A) organopolysiloxane represented by average composition formula:

   R¹¹ₐSiO(₄₋ₐ)_{/2}

   (in the formula, R¹¹ represents an unsubstituted or halogen-substituted monovalent hydrocarbon group, alkoxy group or hydroxyl group, and, per molecule, at least 2 of the R¹¹ groups are alkenyl groups, and at least 5 mol% of all R¹¹ groups are aryl groups, and a is a number from 0.6-2.2);
(B) organopolysiloxane having at least 2 silicon atom-bonded hydrogen atoms per molecule, wherein at least 5 mol% of the silicon atom-bonded groups other than hydrogen atoms are aryl groups {in an amount such that there are 0.1-5 moles of silicon atom-bonded hydrogen atoms in this component, per 1 mole of alkenyl groups in component (A)};
(C) organopolysiloxane represented by average unit formula:

   (R²¹SiO_{3/2})_{b}(R²²SiO_{3/2})_{c}(R²³₂SiO_{2/2})_{d}(R²³₃SiO_{1/2})ₑ (XO_{1/2})_{f}

   {in the formula, R²¹ represents an aryl group, R²² represents an alkenyl group, R²³ independently represents an alkyl group, alkenyl group, aryl group or epoxy-containing organic group, and with respect to the sum of R²¹, R²² and R²³ groups per molecule, at least 5 mol% are alkenyl groups, at least 15 mol% are aryl groups and at least 10 mol% are epoxy-containing organic groups, X represents a hydrogen atom or alkyl group, and b-f, respectively, are such that when the sum of b-e is 1, b is a positive number, c is a positive number, d is 0 or a positive number, e is 0 or a positive number, f is a number from 0-0.02, and c/b is a number from 0.1-5, and b + c is a number from 0.2-0.8} {at 0.1-20 parts by mass per 100 parts by mass of the sum of components (A) and (B)}; and (D) hydrosilylation catalyst in an amount that will promote curing of the inventive composition.

In the inventive composition, component (A) is preferably a linear organopolysiloxane represented by general formula:

R¹²₃SiO(R¹²₂SiO)ₘSiR¹²₃

(in the formula, R¹² independently represents an unsubstituted or halogen-substituted monovalent hydrocarbon group, and, per molecule, at least 2 of the R¹² groups are alkenyl groups, and at least 5 mol% of all R¹² groups are aryl groups, and m is an integer from 5-1000) and/or a branched organopolysiloxane represented by average unit formula:

(R¹²SiO_{3/2})_{g}(R¹²₂SiO_{2/2})ₕ(R¹²₃SiO_{1/2})ᵢ(SiO_{4/2})ⱼ(YO _{1/2})ₖ

{in the formula, R¹² is as described above, and, per molecule, at least 2 of the R¹² groups are alkenyl groups, and at least 5 mol% of all R¹² groups are aryl groups, Y represents a hydrogen atom or alkyl group, and g-k, respectively, are such that when the sum of g-j is 1, g is a positive number, h is 0 or a positive number, i is 0 or a positive number, j is a number from 0-0.3, k is a number from 0-0.4, and h/g is a number from 0-10, and i/g is a number from 0-5}.

Also, in the inventive composition, component (B) is preferably a linear organopolysiloxane represented by general formula:

R³¹₃SiO(R³¹₂SiO)ₙSiR³¹₃

(in the formula, R³¹ independently represents a hydrogen atom or an unsubstituted or halogen-substituted monovalent hydrocarbon group having no unsaturated aliphatic bonds, at least 2 of the R³¹ groups per molecule are hydrogen atoms, and at least 5 mol% of all R³¹ groups excluding the hydrogen atoms are aryl groups, and n is an integer from 1-1000) and/or a branched organopolysiloxane represented by average unit formula:

(R³¹SiO_{3/2})ₚ(R³¹₂SiO_{2/2})_{q}(R³¹₃SiO_{1/2})ᵣ(SiO_{4/2})ₛ(ZO _{1/2})ₜ

{in the formula, R³¹ is as described above, and, per molecule, at least 2 of the R³¹ groups are hydrogen atoms, at least 5 mol% of all R³¹ groups excluding the hydrogen atoms are aryl groups, Z represents a hydrogen atom or alkyl group, and p-t, respectively, are such that when the sum of p-s is 1, p is a positive number, q is 0 or a positive number, r is 0 or a positive number, s is a number from 0-0.3, t is a number from 0-0.4, and q/p is a number from 0-10 and r/p is a number from 0-5}.

The inventive composition may also contain 0.0001-5 parts by mass of (D) hydrosilylation inhibitor, per 100 parts by mass of the sum of components (A) to (C).

The inventive optical semiconductor device is characterized in that the optical semiconductor element is coated with cured product of said curable silicone composition.

### [Effects of the invention]

The inventive curable silicone composition is characterized in that it can form an optical semiconductor device having a light extraction efficiency from the light-emitting element that is good and has a low rate of change. The optical semiconductor device is also characterized in that its light extraction efficiency is good and has a low rate of change over time.

### [Brief description of the drawing]

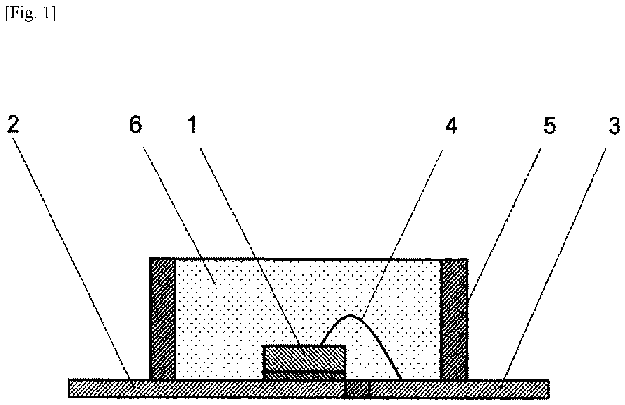

[Figure 1] is a sectional view of an LED that is an example of the inventive semiconductor device.

### [Mode of the invention]

First, the inventive curable silicone composition will be described in detail. Component (A) is an organopolysiloxane represented by average composition formula:

R¹¹ₐSiO(₄₋ₐ)_{/2}

In the formula, R¹¹ represents an unsubstituted or halogen-substituted monovalent hydrocarbon group, alkoxy group or hydroxyl group: specific examples of R¹¹ monovalent hydrocarbon groups are alkyl groups such as methyl, ethyl, propyl, butyl, pentyl, hexyl and heptyl groups; alkenyl groups such as vinyl, allyl, butenyl, pentenyl and hexenyl groups; aryl groups such as phenyl, tolyl, xylyl and naphthyl groups; aralkyl groups such as benzyl and phenethyl groups; and halogen-substituted alkyl groups such as 3-chloropropyl and 3,3,3-trifluoropropyl groups. At least 2 of the R¹¹ groups per molecule are alkenyl groups. These alkenyl groups are preferably vinyl groups. Also, because the resulting cured product has low attenuation due to its light refraction, reflection, scattering, etc., at least 5 mol%, and preferably at least 10 mol%, at least 15 mol%, or at least 20 mol%, of all R¹¹ groups per molecule are aryl groups. These aryl groups are preferably phenyl groups. Also, some of the R¹¹ groups can be alkoxy groups or hydroxyl groups, provided that this does not adversely affect the aim of the present invention. Specific examples of R¹¹ alkoxy groups are methoxy, ethoxy and propoxy groups.

Also, in the formula, a is a number in the range of from 0.6-2.2, and preferably a number in the range of from 0.8-2.2 or a number in the range of from 1.0-2.2. This is because when a is above the lower limit of said range there is improvement in the handling and workability of the inventive composition, and when a is below the upper limit of said range there is improvement in the mechanical characteristics of the cured product obtained on curing the inventive composition.

There are no particular limitations relating to the molecular structure of component (A); for example, it can be linear, linear with some branching, branched or annular, or have two types of structure: linear and branched. Component (A) can be 1 type of organopolysiloxane having such a molecular structure, or a mixture of 2 or more such organopolysiloxanes.

This component (A) is preferably a linear organopolysiloxane represented by general formula:

R¹²₃SiO(R¹²₂SiO)ₘSiR¹²₃

and/or a branched organopolysiloxane represented by average unit formula:

(R¹²SiO_{3/2})_{g}(R¹²₂SiO_{2/2})ₕ(R¹²₃SiO_{1/2})ᵢ(SiO_{4/2})ⱼ(YO _{1/2})ₖ

In the formulae, R¹² independently represents an unsubstituted or halogen-substituted monovalent hydrocarbon group, and examples are the same groups as mentioned above as examples of R¹¹. However, per molecule, at least 2 of the R¹² groups are alkenyl groups. These alkenyl groups are preferably vinyl groups. Also, because the resulting cured product has low attenuation due to its light refraction, reflection, scattering, etc., at least 5 mol%, and preferably at least 10 mol%, at least 15 mol%, or at least 20 mol%, of all R¹² groups per molecule are aryl groups. These aryl groups are preferably phenyl groups.

In the formula, Y represents an alkoxy group or hydroxyl group. Specific examples of alkoxy groups Y are methoxy, ethoxy and propoxy groups.

Also, in the formula, m is an integer in the range of from 5-1000, preferably an integer in the range of from 5-500, an integer in the range of from 10-500, an integer in the range of from 5-300 or an integer in the range of from 10-300. This is because when m is above the lower limit of said range there is improvement in the flexibility of the cured product obtained on curing the inventive composition, and when m is below the upper limit of said range there is improvement in the handling and workability of the inventive composition.

Also, in the formula, g-k, respectively, are such that when the sum of g-j is 1, g is a positive number, h is 0 or a positive number, i is 0 or a positive number, j is a number from 0-0.3, k is a number from 0-0.4, and h/g is a number in the range of from 0-10, and i/g is a number in the range of from 0-5; and preferably, g is a number in the range of from 0.1-0.9, h is a number in the range of from 0-0.6 and i is a number in the range of from 0-0.8. This is because when g is above the lower limit of said range there is improvement in the mechanical strength of the cured product of the inventive composition, and when g is below the upper limit of said range there is improvement in the flexibility of the cured product. It is also because when h and i are within said ranges there is improvement in the mechanical strength of the cured product.

Component (B) is an organopolysiloxane having at least 2 silicon atom-bonded hydrogen atoms per molecule. Examples of silicon atom-bound groups (other than hydrogen atoms) in component (B) are unsubstituted or halogen-substituted monovalent hydrocarbon groups having no aliphatic unsaturated bonds, and specific examples are alkyl groups such as methyl, ethyl, propyl, butyl, pentyl, hexyl and heptyl groups; aryl groups such as phenyl, tolyl, xylyl and naphthyl groups; aralkyl groups such as benzyl and phenethyl groups; and halogenated alkyl groups such as 3-chloropropyl and 3,3,3-trifluoropropyl groups. Because the resulting cured product has low attenuation due to its light refraction, reflection, scattering, etc., per molecule at least 5 mol%, and preferably at least 10 mol%, at least 15 mol%, or at least 20 mol%, of the silicon atom-bound groups (other than hydrogen atoms) are aryl groups. Alkoxy groups or hydroxyl groups can also be bonded to the silicon atoms in the molecule, provided that this does not adversely affect the aim of the present invention. Specific examples of these alkoxy groups are methoxy, ethoxy and propoxy groups.

There are no particular limitations relating to the molecular structure of component (B); for example, it can be linear, linear with some branching, branched or annular, or have two types of structure: linear and branched. Component (B) can also be 1 type of organopolysiloxane having such a molecular structure, or a mixture of 2 or more such organopolysiloxanes.

This component (B) is preferably a linear organopolysiloxane represented by general formula:

R³¹₃SiO(R³¹₂SiO)ₙSiR³¹₃

and/or a branched organopolysiloxane represented by average unit formula:

(R³¹SiO_{3/2})ₚ(R³¹₂SiO_{2/2})_{q}(R³¹₃SiO_{1/2})ᵣ(SiO_{4/2})ₛ(Z O_{1/2})ₜ

In the formula, R³¹ independently represents a hydrogen atom, or an unsubstituted or halogen-substituted monovalent hydrocarbon group having no aliphatic unsaturated bonds. Specific examples of monovalent hydrocarbon groups R³¹ are alkyl groups such as methyl, ethyl, propyl, butyl, pentyl, hexyl and heptyl groups; aryl groups such as phenyl, tolyl, xylyl and naphthyl groups; aralkyl groups such as benzyl and phenethyl groups; and halogenated alkyl groups such as 3-chloropropyl and 3,3,3-trifluoropropyl groups. At least 2 of the R³¹ groups per molecule are hydrogen atoms. Also, because the resulting cured product has low attenuation due to its light refraction, reflection, scattering, etc., per molecule at least 5 mol%, and preferably at least 10 mol%, at least 15 mol%, or at least 20 mol%, of all R³¹ groups (except the hydrogen atoms) are aryl groups. These aryl groups are preferably phenyl groups.

In the formula, Z represents an alkoxy group or hydroxyl group. Specific examples of alkoxy groups Z are methoxy, ethoxy and propoxy groups.

Also, in the formula, n is an integer in the range of from 1-1000, preferably an integer in the range of from 1-500, an integer in the range of from 1-300, an integer in the range of from 1-100, or an integer in the range of from 1-50. This is because when n is above the lower limit of said range the inventive composition is stable, and when n is below the upper limit of said range there is improvement in the handling and workability of the inventive composition.

Also, in the formula, p-t, respectively, are such that when the sum of p-s is 1, p is a positive number, q is 0 or a positive number, r is 0 or a positive number, s is a number from 0-0.3, t is a number from 0-0.4, and q/p is a number from 0-10, r/p is a number from 0-5; and preferably, p is a number from 0.1-0.6 and r is a number from 0.3-0.9. This is because when p-t are in said ranges there is improvement in the mechanical strength of the resulting cured product.

The amount of component (B) is such that there are in the range of from 0.1-5 moles, preferably in the range of from 0.5-5 moles, in the range of from 0.5-3 moles, or in the range of from 0.5-2 moles, of silicon atom-bonded hydrogen atoms per 1 mole of alkenyl groups in component (A). This is because when the amount of component (B) is less than the lower limit of said range the resulting composition tends not to cure sufficiently, and when the amount of component (B) exceeds the upper limit of said range the heat resistance of the resulting cured product tends to decrease.

Component (C) is an organopolysiloxane represented by average unit formula:

(R²¹SiO_{3/2})_{b}(R²²SiO_{3/2})_{c}(R²³₂SiO_{2/2})_{d}(R²³₃SiO_{1/2})ₑ (XO_{1/2})_{f}

In the formula, R²¹ is an aryl group; examples are phenyl, tolyl, xylyl and naphthyl groups, and it is preferably a phenyl group.

In the formula, R²² is an alkenyl group; examples are vinyl, allyl, butenyl, pentenyl and hexenyl groups, and it is preferably a vinyl group.

Also, in the formula, R²³ independently represents an alkyl, alkenyl or aryl group, or an epoxy-containing organic group. Specific examples of R²³ alkyl groups are methyl, ethyl, propyl, butyl, pentyl, hexyl and heptyl groups, and it is preferably a methyl group. Specific examples of R²³ alkenyl groups are vinyl, allyl, butenyl, pentenyl and hexenyl groups, and it is preferably a vinyl group. Specific examples of R²³ aryl groups are phenyl, tolyl, xylyl and naphthyl groups, and it is preferably a phenyl group. Specific examples of R²³ epoxy-containing organic groups are 3-glycidoxypropyl, 3,4-epoxycyclohexylethyl, 3,4-epoxybutyl and 5,6-epoxyhexyl groups, and it is preferably a 3-glycidoxypropyl group.

Per molecule, at least 5 mol%, preferably at least 8 mol%, of the sum of the R²¹, R²² and R²³ groups are alkenyl groups. This is because when the alkenyl group content is above said lower limit it is possible to improve the mechanical strength of the resulting cured product.

Per molecule, at least 15 mol%, preferably at least 25 mol%, of the sum of the R²¹, R²² and R²³ groups are aryl groups. This is because when the aryl group content is above said lower limit, compatibility with other components improves and the refractive index of the resulting cured product increases.

Also, per molecule, at least 10 mol%, preferably at least 20 mol%, of the sum of the R²¹, R²² and R²³ groups are epoxy-containing organic groups. This is because when the epoxy-containing organic group content is above said lower limit there is improvement in the adhesiveness to substrates such as case resin.

In the formula, X represents an alkoxy group or hydroxyl group. Specific examples of alkoxy groups X are methoxy, ethoxy and propoxy groups.

Also, in the formula, b-f, respectively, are such that when the sum of b-e is 1, b is a positive number, c is a positive number, d is 0 or a positive number, e is 0 or a positive number, f is a number from 0-0.02, and c/b is a number from 0. 1-5 and c + b is a number from 0.2-0.8. This is because when b-f are in said ranges the inventive composition exhibits appropriate curability, and when the inventive composition is used as light-emitting element sealant in an optical semiconductor device, the light extraction efficiency from the light-emitting element is good and a low rate of change can be achieved.

There are no particular limitations relating to the viscosity of component (C) at 25°C, and it is preferably in the range of from 100-50,000 mPa s or in the range of from 1000-20,000 mPa s. This is because when the viscosity of component (C) at 25°C is in said range there is improvement in the adhesiveness of the inventive composition to substrates such as case resin.

The amount of component (C) is in the range of from 0.1-20 parts by mass, preferably in the range of from 0.1-10 parts by mass, or in the range of from 0.2-10 parts by mass, per 100 parts by mass of the sum of components (A) and (B). This is because when the amount of component (C) is above said lower limit the light extraction efficiency from the resulting optical semiconductor device is good and a low rate of change can be achieved, and when the amount component (C) is below said upper limit discoloration of the resulting cured product can be inhibited.

Component (D) is a hydrosilylation catalyst for promoting curing of the inventive composition. Examples of component (D) are platinum catalysts, rhodium catalysts and palladium catalysts, and platinum catalysts are preferred because they can markedly promote curing of the inventive composition. Examples of the platinum catalysts are platinum fine powder, chloroplatinic acid, alcohol solution of chloroplatinic acid, platinum-alkenylsiloxane complexes, platinum-olefin complexes and platinum-carbonyl complexes; platinum-alkenylsiloxane complexes are particularly preferred.

Examples of the alkenylsiloxanes are 1,3-divinyl-1,1,3,3-tetramethyldisiloxane; 1,3,5,7-tetramethyl-1,3,5,7-tetravinylcyclotetrasiloxane; the substituted alkenylsiloxanes obtained by substituting some of the methyl groups of these alkenylsiloxanes with ethyl groups, phenyl groups, etc.; and substituted alkenylsiloxanes obtained by substituting some of the vinyl groups of these alkenylsiloxanes with allyl groups hexenyl groups, etc. 1,3-Divinyl-1,1,3,3-tetramethyldisiloxane is particularly preferred, because the platinum-alkenylsiloxane complex has good stability.

It is also preferable to add to the platinum-alkenylsiloxane complex an alkenylsiloxane such as 1,3-divinyl-1,1,3,3-tetramethyldisiloxane, 1,3-diallyl-1,1,3,3-tetramethyldisiloxane, 1,3-divinyl-1,3-dimethyl-1,3-diphenyldisiloxane, 1,3-divinyl-1,1,3,3-tetraphenyldisiloxane or 1,3,5,7-tetramethyl-1,3,5,7-tetravinylcyclotetrasiloxane, or an organosiloxane oligomer such as dimethylsiloxane oligomer, because this can improve the stability of the complex; it is particularly preferable to add an alkenylsiloxane.

The amount of component (D) is an amount that will promote curing of the inventive composition; specifically, it is preferably an amount such that the mass unit of the metal atoms in component (D) is in the range of from 0.01-500 ppm, in the range of from 0.01-100 ppm or in the range of from 0.01-50 ppm, with respect to the inventive composition. This is because when the amount of component (D) is less than the lower limit of said ranges the inventive composition tends not to cure sufficiently, and when the amount of component (D) exceeds the upper limit of said ranges there may be problems such as coloration of the resulting cured product.

In order to improve the handling and workability of the inventive composition, (E) hydrosilylation inhibitor may be incorporated. Examples of this component (E) are alkyne alcohols such as 2-methyl-3-butyn-2-ol, 3,5-dimethyl-1-hexyn-3-ol and 2-phenyl-3-butyn-2-ol; enyne compounds such as 3-methyl-3-penten-1-yne and 3,5-dimethyl-3-hexen-1-yne; and 1,3,5,7-tetramethyl-1,3,5,7-tetravinylcyclotetrasiloxane, 1,3,5,7-tetramethyl-1,3,5,7-tetrahexenylcyclotetrasiloxane, and benzotriazole.

There are no particular limitations relating to the amount of component (E), and it is in the range of from 0.0001-5 parts by mass, preferably in the range of from 0.0001-2 parts by mass, per 100 parts by mass of the sum of said components (A) to (C). This is because when the amount of component (E) is above the lower limit of said ranges there is improvement in the pot-life and workability of the inventive composition, and when it is below the upper limit of said ranges there is improvement in the curability of the inventive composition.

The inventive composition forms a transparent cured product and so this can be used for lens material and the like; furthermore, phosphors may be incorporated into the inventive composition in order to convert to the desired wavelength the light emitted from the light-emitting element that is sealed or coated with cured product of the inventive composition. Examples of such a phosphor are yellow-, red-, green-, and blue-emitting phosphors comprising oxide phosphors, oxynitride phosphors, nitride phosphors, sulfide phosphors, oxysulfide phosphors, etc., which are widely used in light-emitting diodes (LEDs). Examples of oxide phosphors are cerium ion-containing yttrium aluminum garnet (YAG) green-yellow-emitting phosphors, cerium ion-containing terbium aluminum garnet (TAG) yellow-emitting phosphors and cerium and europium ion-containing silicate green-yellow-emitting phosphors. Examples of oxynitride phosphors are europium ion-containing silicon-, aluminum-, oxygen-, and nitrogen-based SiAlON red-green-emitting phosphors. Examples of nitride phosphors are europium ion-containing calcium-, strontium-, aluminum-, silicon- and nitrogen-based CASN red-emitting phosphors. Examples of sulfide phosphors are copper ion- and aluminum ion-containing ZnS green-emitting phosphors. Examples of oxysulfide phosphors are europium ion-containing Y₂O₂S red-emitting phosphors. One or a mixture of 2 or more of these phosphors may be used.

There are no particular limitations relating to the amount of phosphor in the inventive composition, and in order to sufficiently convert the wavelength of the light emitted from the light-emitting element, there are preferably in the range of from 0-250 parts by mass,in the range of from 1-100 parts by mass, in the range of from 1-50 parts by mass or in the range of from 1-30 parts by mass, per 100 parts by mass of the sum of components (A) to (D).

Furthermore, provided that the aim of the present invention is not adversely affected, the inventive composition can also contain, as optional components, inorganic filler such as silica, glass, alumina or zinc oxide; organic resin fine powder such as methacrylate resin; and heat resistant agent, dye, pigment, flame retardant, solvent, etc.

There are no particular limitations relating to the 25°C viscosity of the inventive composition, and it is preferably in the range of from 100-1,000,000 mPa s, or in the range of from 500-50,000 mPa s. This is because when the viscosity is below the lower limit of said range the mechanical strength of resulting cured product tends to decrease, and when it exceeds the upper limit of said range the handling and workability of the resulting composition tend to decrease.

The curing of the inventive composition proceeds at room temperature or on heating, and heating is preferred because it allows rapid curing. The heating temperature is preferably in the range of from 50-200°C.

Next, the optical semiconductor device of the present invention will be described in detail. The inventive optical semiconductor device is characterized in that the optical semiconductor element is sealed using cured product of said curable silicone composition. Examples of inventive optical semiconductor devices are light-emitting diodes (LEDs), photocouplers and CCDs. Examples of light-emitting elements are light-emitting diode (LED) chips and solid-state imaging elements.

Figure 1 shows a sectional view of a single surface mount LED, which is an example of an inventive optical semiconductor device. The LED shown in Figure 1 comprises light-emitting element (LED chip) 1 die-bonded onto lead frame 2, with light-emitting element (LED chip) 1 and lead frame 3 wire-bonded by bonding wire 4. Frame 5 is provided around light-emitting element (LED chip) 1, and light-emitting element (LED chip) 1 is sealed inside frame 5 using cured product 6 of inventive curable silicone composition.

An example of a method for producing a surface mount LED, as shown in Figure 1, is a method wherein light-emitting element (LED chip) 1 is die-bonded onto lead frame 2, this light-emitting element (LED chip) 1 and lead frame 3 are wire-bonded using metal bonding wire 4, then inventive curable silicone composition is loaded inside frame 5, provided around light-emitting element (LED chip) 1, and cured by heating at 50-200°C.

### [Examples]

The inventive curable silicone composition and optical semiconductor device are described in more detail below by means of examples and comparative examples. It should be noted that viscosity refers to the value at 25°C. The following components were used to prepare the curable silicone compositions of the examples and comparative examples. In the formulae, Me, Ph, Vi and Ep denote methyl group, phenyl group, vinyl group and 3-glycidoxypropyl group, respectively.

The following components were used as component (A).
(a1) Methylphenylpolysiloxane having both molecular chain terminals dimethylvinylsiloxy group-blocked, represented by average formula:

   ViMe₂SiO(MePhSiO)₂₃SiMe₂Vi

   and average composition formula:

   Me_{1.08}Ph_{0.92}Vi_{0.08}SiO_{0.96}

   (phenyl group content = 44.2 mol%)
(a2) Dimethyldiphenylpolysiloxane having both molecular chain terminals dimethylvinylsiloxy group-blocked, represented by average formula:

   ViMe₂SiO(Me₂SiO)₂₀₀(Ph₂SiO)₅₀SiMe₂Vi

   and average composition formula:

   Me_{1.60}Ph_{0.40}Vi_{0.01}SiO_{1.00}

   (phenyl group content = 19.8 mol%)
(a3) Dimethylpolysiloxane having both molecular chain terminals diphenylvinylsiloxy group-blocked, represented by average formula:

   ViPh₂SiO(Me₂SiO)_{11.3}SiPh₂Vi

   and average composition formula:

   Me_{1.70}Ph_{0.30}Vi_{0.15}SiO_{0.93}

   (phenyl group content = 14.0 mol%)
(a4) Organopolysiloxane having at least 2 vinyl groups per molecule, represented by average unit formula:

   (Me₂ViSiO_{1/2})_{0.25}(PhSiO_{3/2})_{0.75}

   and average composition formula:

   Me_{0.50}Ph_{0.75}Vi_{0.25}SiO_{1.25}

   (phenyl group content = 50.0 mol%)
(a5) Organopolysiloxane having at least 2 vinyl groups per molecule, represented by average unit formula:

   (Me₂ViSiO_{1/2})_{0.11}(Me₃SiO_{1/2})₀.₁₄(MeSiO_{3/2})_{0.53}(Ph SiO_{3/2})_{0.22}

   and average composition formula:

   Me_{1.17}Ph_{0.22}Vi_{0.11}SiO_{1.25}

   (phenyl group content = 14.7 mol%)
(a6) Organopolysiloxane having at least 2 vinyl groups per molecule, represented by average unit formula:

   (Me₂ViSiO_{1/2})_{0.20}(PhSiO_{3/2})_{0.80}

   and average composition formula:

   Me_{0.40}Ph_{0.80}Vi_{0.20}SiO_{1.30}

   (phenyl group content = 57.1 mol%)

The following components were used as component (B).
(b1) Organotrisiloxane represented by formula:

   HMe₂SiO(Ph₂SiO)SiMe₂H

   (phenyl group content = 33.3 mol%)
(b2) Organopolysiloxane having at least 2 silicon atom-bonded hydrogen atoms per molecule, represented by average unit formula:

   (HMe₂SiO_{1/2})_{0.60}(PhSiO_{3/2})_{0.40}

   (phenyl group content = 25.0 mol%)

The following components were used as component (C).
(c1) Organopolysiloxane having a viscosity of 4800 mPa s, represented by average unit formula:

   (ViSiO_{3/2})_{0.21}(PhSiO_{3/2})_{0.31}(EpMeSiO_{2/2})_{0.48}

   (vinyl group content = 14.2 mol%, phenyl group content = 21.0 mol%, 3-glycidoxypropyl group content = 32.4 mol%)
(c2) Organopolysiloxane having a viscosity of 6000 mPa s, represented by average unit formula:

   (ViSiO_{3/2})_{0.24}(PhSiO_{3/2})_{0.27}(EpMeSiO_{2/2})_{0.49}

   (vinyl group content = 16.1 mol%, phenyl group content = 18.1 mol%, 3-glycidoxypropyl group content = 32.9 mol%)
(c3) Organopolysiloxane having a viscosity of 7000 mPa s, represented by average unit formula:

   (ViSiO_{3/2})_{0.15}(PhSiO_{3/2})_{0.31}(EpMeSiO_{2/2})_{0.54}

   (vinyl group content = 9.7 mol%, phenyl group content = 20.1 mol%, 3-glycidoxypropyl group content = 35.1 mol%)
(c4) Organopolysiloxane having a viscosity of 19,000 mPa s, represented by average unit formula:

   (PhSiO_{3/2})_{0.53}(EpMeSiO_{2/2})_{0.29}(Me₂ViSiO_{1/2})_{0.18}

   (vinyl group content = 10.9 mol%, phenyl group content = 32.1 mol%, 3-glycidoxypropyl group content = 17.6 mol%)

The following component was used as component (D).
(d) 1,3-Divinyl-1,1,3,3-tetramethyldisiloxane solution of platinum 1,3-divinyl-1,1,3,3-tetramethyldisiloxane complex having a platinum metal content of approximately 4% by mass

The following components were used as component (E).
(e1)1-Ethynylcyclohexan-1-ol
(e2) Annular methylvinylpolysiloxane represented
   by average formula:

   (MeViSiO)₄

In the examples and comparative examples, the characteristics of the curable silicone compositions were measured as follows.

### [Refractive index of curable silicone composition]

The refractive index of each curable silicone composition was measured at 25°C using an Abbe refractometer. It should be noted that visible light (589 nm) was used as the light source.

### [Initial viscosity of curable silicone composition and time taken for viscosity to reach 50,000 mPa s]

Immediately after each curable silicone composition was prepared, its viscosity (mPa s) at 25°C was measured using a rotational viscometer (E-type viscometer, "Visconic EMD" manufactured by Tokimec Co., Ltd.). The time taken for its viscosity, at 25°C, to reach 50,000 mPa s was also measured.

In the examples and comparative examples, the characteristics of the surface-mounted light-emitting diodes (LEDs) prepared using the curable silicone compositions were measured as follows.

### [Optical semiconductor device light extraction efficiency and rate of change thereof over time]

1.035 g Green phosphor
(GAL530, manufactured by Intematix) and 0.082 g red phosphor (ER6535, manufactured by Intematix) were added to and mixed uniformly with 5 g of curable silicone composition of Examples 1-5 and Comparative examples 1 and 2, respectively, to prepare 7 types of curable silicone composition. Optical semiconductor devices were prepared by injecting these curable silicone compositions into optical semiconductor devices as shown in Figure 1, and curing at 150°C for 2 hours. The light extraction efficiency of these optical semiconductor devices was found by measuring the radiant flux using a total radiant flux meter employing an integrating sphere.

Also, these optical semiconductor devices were aged at 85°C, 85% RH for 500 hours, and then the light extraction efficiency of the respective optical semiconductor devices was measured as described above. This light extraction efficiency was used to find the rate of change with respect to the initial light extraction efficiency (retention rate %).

### [Examples 1-6, comparative examples 1 and 2]

Curable silicone compositions were prepared using the compositions shown in Table 1. It should be noted that in Table 1, "SiH/Vi" denotes the sum of the number of moles of silicon atom-bonded hydrogen atoms in component (B) per 1 mole of the sum of the vinyl groups in component (A). The characteristics of the curable silicone compositions and the characteristics of the optical semiconductor devices manufactured using these compositions are also shown in Table 1.

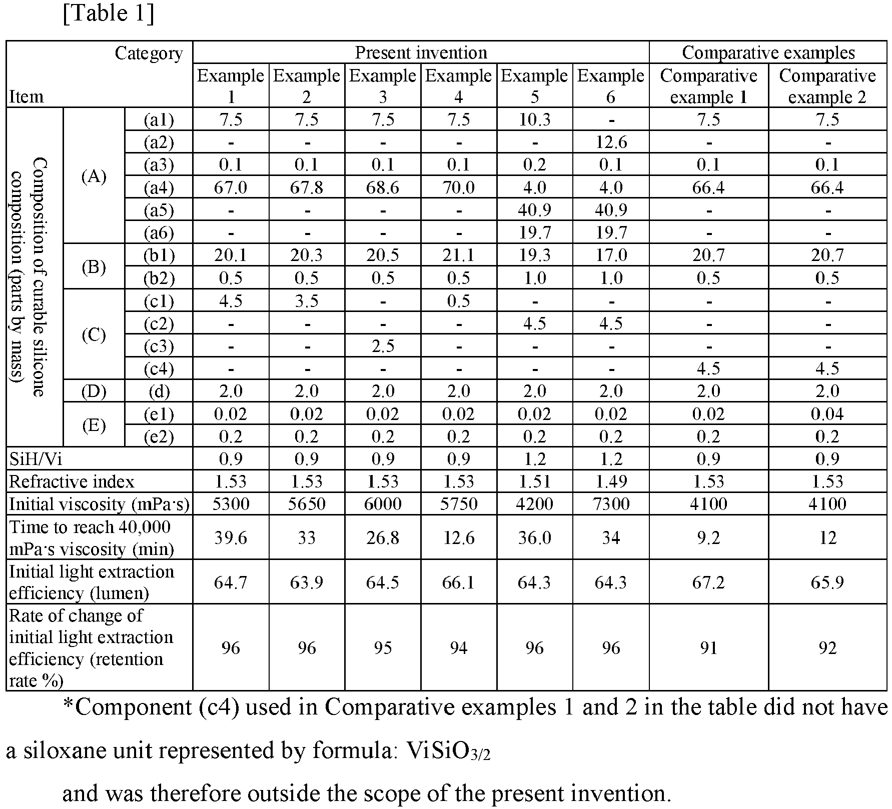

It is clear from Table 1 that the inventive curable silicone compositions have excellent initial light extraction efficiency and a small change in light extraction efficiency over time.

### [Industrial applicability]

The inventive curable silicone composition can form an optical semiconductor device having a light extraction efficiency from the light-emitting element that is good and has a low rate of change, and so the inventive curable silicone composition is suitable as sealant or coating for light-emitting elements in optical semiconductor devices such as light-emitting diodes (LEDs). Also, the inventive curable silicone composition retains good transparency and is therefore also suitable as optical members for which transparency is required.

### [Figure legend]

- 1: Light-emitting element
- 2: Lead frame
- 3: Lead frame
- 4: Bonding wire
- 5: Frame
- 6: Cured product of curable silicone composition

## Claims

1. Curable silicone composition containing at least
(A) organopolysiloxane represented by average composition formula:
R¹¹ₐSiO(₄₋ₐ)_{/2}
(in the formula, R¹¹ represents an unsubstituted or halogen-substituted monovalent hydrocarbon group, alkoxy group or hydroxyl group, and, per molecule, at least 2 of the R¹¹ groups are alkenyl groups, and at least 5 mol% of all R¹¹ groups are aryl groups, and a is a number from 0.6-2.2);
(B) organopolysiloxane having at least 2 silicon atom-bonded hydrogen atoms per molecule, wherein at least 5 mol% of the silicon atom-bonded groups other than hydrogen atoms are aryl groups {in an amount such that there are 0.1-5 moles of silicon atom-bonded hydrogen atoms in this component, per 1 mole of alkenyl groups in component (A)};
(C) organopolysiloxane represented by average unit formula:
(R²¹SiO_{3/2})_{b}(R²²SiO_{3/2})_{c}(R²³₂SiO_{2/2})_{d}(R²³₃SiO_{1/2})ₑ (XO_{1/2})_{f}
{in the formula, R²¹ represents an aryl group, R²² represents an alkenyl group, R²³ independently represents an alkyl group, alkenyl group, aryl group or epoxy-containing organic group, and with respect to the sum of the R²¹, R²² and R²³ groups per molecule, at least 5 mol% are alkenyl groups, at least 15 mol% are aryl groups and at least 10 mol% are epoxy-containing organic groups, X represents a hydrogen atom or alkyl group, and b-f, respectively, are such that when the sum of b-e is 1, b is a positive number, c is a positive number, d is 0 or a positive number, e is 0 or a positive number, f is a number from 0-0.02, and c/b is a number from 0.1-5, and b + c is a number from 0.2-0.8} {at 0.1-20 parts by mass per 100 parts by mass of the sum of components (A) and (B)}; and
(D) hydrosilylation catalyst in an amount that will promote curing of the inventive composition.

2. The curable silicone composition as claimed in claim 1, where component (A) is a linear organopolysiloxane represented by general formula:
R¹²₃SiO(R¹²₂SiO)ₘSiR¹²₃
(in the formula, R¹² independently represents unsubstituted or halogen-substituted monovalent hydrocarbon groups, and, per molecule, at least 2 of the R¹² groups are alkenyl groups, and at least 5 mol% of all R¹² groups are aryl groups, and m is an integer from 5-1000) and/or a branched organopolysiloxane represented by average unit formula:
(R¹²SiO_{3/2})_{g}(R¹²₂SiO_{2/2})ₕ(R¹²₃SiO_{1/2})ᵢ(SiO_{4/2})ⱼ(YO _{1/2})ₖ
{in the formula, R¹² is as described above, and, per molecule, at least 2 of the R¹² groups are alkenyl groups, and at least 5 mol% of all R¹² groups are aryl groups, Y represents a hydrogen atom or alkyl group, and g-k, respectively, are such that when the sum of g-j is 1, g is a positive number, h is 0 or a positive number, i is 0 or a positive number, j is a number from 0-0.3, k is a number from 0-0.4, and h/g is a number from 0-10, and i/g is a number from 0-5}.

3. The curable silicone composition as claimed in claim 1, where component (B) is a linear organopolysiloxane represented by general formula:
R³¹₃SiO(R³¹₂SiO)ₙSiR³¹₃
(in the formula, R³¹ independently represents a hydrogen atom, or an unsubstituted or halogen-substituted monovalent hydrocarbon group having no unsaturated aliphatic bonds, at least 2 of the R³¹ groups per molecule are hydrogen atoms, and at least 5 mol% of all R³¹ groups excluding the hydrogen atoms are aryl groups, and n is an integer from 1-1000) and/or a branched organopolysiloxane represented by average unit formula:
(R³¹SiO_{3/2})ₚ(R³¹₂SiO_{2/2})_{q}(R³¹₃SiO_{1/2})ᵣ(SiO_{4/2})ₛ(ZO _{1/2})ₜ
{in the formula, R³¹ is as described above, and, per molecule, at least 2 of the R³¹ groups are hydrogen atoms, at least 5 mol% of all R³¹ groups excluding the hydrogen atoms are aryl groups, Z represents a hydrogen atom or alkyl group, and p-t, respectively, are such that when the sum of p-s is 1, p is a positive number, q is 0 or a positive number, r is 0 or a positive number, s is a number from 0-0.3, t is a number from 0-0.4, and q/p is a number from 0-10 and r/p is a number from 0-5}.

4. The curable silicone composition as claimed in any of claims 1 to 3, where furthermore the amount of hydrosilylation inhibitor (D) is 0.0001-5 parts by mass per 100 parts by mass of the sum of components (A) to (C).

5. Optical semiconductor device containing an optical semiconductor element that is coated with curable silicone composition as claimed in any of claims 1 to 4.
